# FASCICULE DE BREVET EUROPEEN

(11) **EP 3 396 704 B1**
(45) Date de publication et mention de la délivrance du brevet: **09.03.2022**
(21) Numéro de dépôt: 18169066.0
(22) Date de dépôt: 24.04.2018
(51) Int. Cl.: H01L 21/311, H01L 21/8234, H01L 21/8238, H01L 29/66, H01L 21/3115

(54) **PROCÉDÉ DE GRAVURE D'UNE COUCHE À BASE DE SIN**
GRAVIERVERFAHREN EINER SCHICHT AUF SIN-BASIS
METHOD FOR ETCHING A LAYER MADE OF SIN

(30) Priorité: 25.04.2017 FR 1753542
(43) Date de publication de la demande: 31.10.2018
(73) Titulaire: Commissariat à l'Energie Atomique et aux Energies Alternatives, 75015 Paris (FR)
(72) Inventeur: POSSEME, Nicolas, 38360 SASSENAGE (FR)
(74) Mandataire: Hautier, Nicolas

(56) Documents cités:
- EP-A1- 2 750 170
- EP-A2- 2 999 001
- US-A1- 2013 157 470

## Description

### DOMAINE TECHNIQUE DE L'INVENTION

La présente invention concerne en général les techniques de gravure d'une couche à base de nitrure de silicium. Elle trouvera pour application particulièrement avantageuse mais non limitative la réalisation sur un même substrat de transistors présentant des espaceurs à base de nitrure de silicium et des caractéristiques différentes, par exemple des dopages de type N et P ou des oxydes de grille dont les épaisseurs sont différentes. Elle trouvera pour application avantageuse la réalisation de tels transistors sur un substrat de type FDSOI.

### ÉTAT DE LA TECHNIQUE

Les couches à base de nitrure de silicium sont très largement utilisées dans de nombreux dispositifs et procédés micro-électroniques. C'est en particulier le cas dans la réalisation d'espaceurs de grille de transistors. Une difficulté consiste à graver de manière sélective la couche de nitrure de silicium dans certaines zones, typiquement en dehors des flancs de la grille, tout en conservant une épaisseur de nitrure de silicium en d'autres zones, typiquement sur les flancs de la grille.

En effet, lors de la gravure du nitrure de silicium, les procédés actuels conduisent bien souvent à graver de manière incomplète la couche de nitrure de silicium (on parle alors de « sous gravure ») ou à graver de manière involontaire la couche de silicium sous-jacente (on parle alors de « sur gravure »), formant typiquement un canal pour le transistor. Par ailleurs, il est également délicat de graver de manière sélective le nitrure de silicium par rapport à la couche d'oxyde de silicium avoisinante formant des tranchées d'isolation (habituellement appelées Shallow Trench Isolation (STI)) isolant les transistors, Ces consommations involontaires de silicium ou d'oxyde de silicium conduisent à détériorer de manière significative les performances du transistor.

De nombreuses solutions ont été recherchées pour améliorer la sélectivité de la gravure des couches à base de nitrure de silicium par rapport aux couches de silicium et d'oxyde de silicium.

Les différentes solutions connues, conduisent inévitablement à une consommation souvent incontrôlée des couches sous-jacentes ou à une gravure incomplète de la couche de nitrure de silicium.

Il existe donc un besoin consistant à proposer une solution pour améliorer la sélectivité de la gravure du nitrure de silicium vis-à-vis du silicium et de l'oxyde de silicium.

Cette problématique est d'autant plus prégnante lorsqu'il est nécessaire de réaliser sur un même substrat, des transistors présentant des caractéristiques différentes, par exemple des transistors de type N et des transistors de type P et qu'une gravure doit intervenir sur les transistors de l'un de ces types alors que les transistors de l'autre type sont déjà formés et ne sont plus protégés.

Le document EP 2 750 170 A1 décrit un procédé de gravure d'une couche à base de nitrure de silicium comprenant la modification de la couche par implantation d'ions légers et le retrait successif de la zone modifiée par un plasma comprenant CH3F et O2.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Selon un premier mode de réalisation, l'invention concerne un procédé microélectronique de gravure d'une couche à base de nitrure de silicium comprenant les étapes successives suivantes:
- modification de la couche à base de nitrure de silicium (SiN) de manière à former au moins une zone modifiée, la modification comprenant au moins une implantation, de préférence par plasma, d'ions légers dans la couche à base de SiN;
- retrait de l'au moins une zone modifiée ;

Le retrait de l'au moins une zone modifiée comprend au moins une étape de gravure de préférence par plasma de l'au moins une zone modifiée utilisant une chimie comprenant au moins:
∘ au moins un composé pris parmi les composés fluorocarbonés (CₓF_{z}) ou les composés hydrofluorocarbonés (CₓH_{y}F_{z}), et
∘ au moins un composé pris parmi le Si_{w}Cl(2_{w}+2) et le Si_{w}F(2_{w}+2),
∘ au moins un composé pris parmi l'oxygène ou l'azote.

De préférence x, y, z et w sont des entiers. De préférence w = 1 ou w = 2.

Il s'est avéré que, de manière particulièrement avantageuse et inattendue, le procédé selon la présente invention permet de graver efficacement la couche à base de SiN, sans consommer d'autres matériaux tels que du silicium ou du dioxyde de silicium. Par ailleurs, cette chimie de gravure est particulièrement sélective aux zones et portions non modifiées de la couche à base de SiN.

L'invention permet ainsi d'améliorer considérablement le contrôle dimensionnel tout en n'altérant pas les couches sous-jacentes ou avoisinantes faites en matériaux semi-conducteurs ou diélectriques. Les dispositifs microélectroniques réalisés selon la présente invention présentent donc des performances améliorées.

Une étape de gravure par plasma de l'au moins une zone modifiée utilisant une chimie comprenant au moins au moins un composé pris parmi le Si_{w}Cl(2_{w}+2) en plus du composé comprenant au du moins CₓF_{z} ou du CₓH_{y}F_{z} offre des résultats particulièrement efficaces en termes de sélectivité de gravure.

Par ailleurs, l'invention s'avère particulièrement efficace pour réaliser sur un même substrat, des transistors présentant des caractéristiques différentes, par exemple des transistors de type N et des transistors de type P. Avec les procédés connus, une étape très délicate consiste à réaliser une gravure anisotrope sur une couche de SiN recouvrant les transistors de l'un seulement de ces types alors que les transistors de l'autre type sont déjà formés et ne sont plus protégés par la couche de SiN. Les solutions connues conduisent bien souvent à altérer les couches des transistors qui ne sont plus protégés ou à dégrader la couche semi-conductrice ou la couche isolante.

On notera que toutes les étapes de ce procédé agissent en synergie pour permettre une gravure particulièrement précise et sélective des zones modifiées de la couche à base de SiN vis-à-vis des zones non modifiées de cette couche, vis-à-vis de la couche en un matériau semi-conducteur tel que du silicium ou du germanium et vis-à-vis de la couche isolante faite par exemple d'un oxyde de silicium.

L'association d'une chimie à base de FC et de SiCl4 ne permettrait pas de graver efficacement la couche à base de SiN.

Par ailleurs, l'utilisation d'une chimie fluorocarbonée sur des zones modifiées par implantation d'hydrogène conduirait à une sélectivité bien moins importante.

Dans le but d'améliorer la sélectivité de la gravure d'une couche à base de SiN, l'homme du métier envisagerait éventuellement l'utilisation d'une solution à base d'acide fluorhydrique (FH) et essayerait de modifier les paramètres de cette gravure. Au mieux, il utiliserait de l'acide fluorhydrique sous forme de vapeur. Éventuellement, il modifierait le pH de l'acide fluorhydrique pour améliorer la sélectivité.

En aucune manière, l'homme du métier ne se tournerait de manière évidente vers le procédé revendiqué.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les FIGURES 1a à 1d illustrent des étapes d'un mode de réalisation du procédé selon l'invention appliqué à une couche à base de nitrure de silicium déposée sur un substrat plan.
Les FIGURES 2a à 2b illustrent des étapes d'un mode de réalisation du procédé selon l'invention appliqué à une couche à base de nitrure de silicium déposée sur un motif, le motif formant dans cet exemple non limitatif un empilement de grille d'un transistor.
Les FIGURES 3a à 3h illustrent des étapes d'un mode de réalisation du procédé selon l'invention appliqué à un substrat sur lequel sont formés plusieurs motifs, les motifs formant dans cet exemple non limitatif des empilements de grille de transistor.
La FIGURE 4 résume certaines étapes du mode de réalisation illustré en figures 3a à 3h.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches ne sont pas représentatives de la réalité.

### DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Une couche peut par ailleurs être composée de plusieurs sous-couches d'un même matériau ou de matériaux différents.

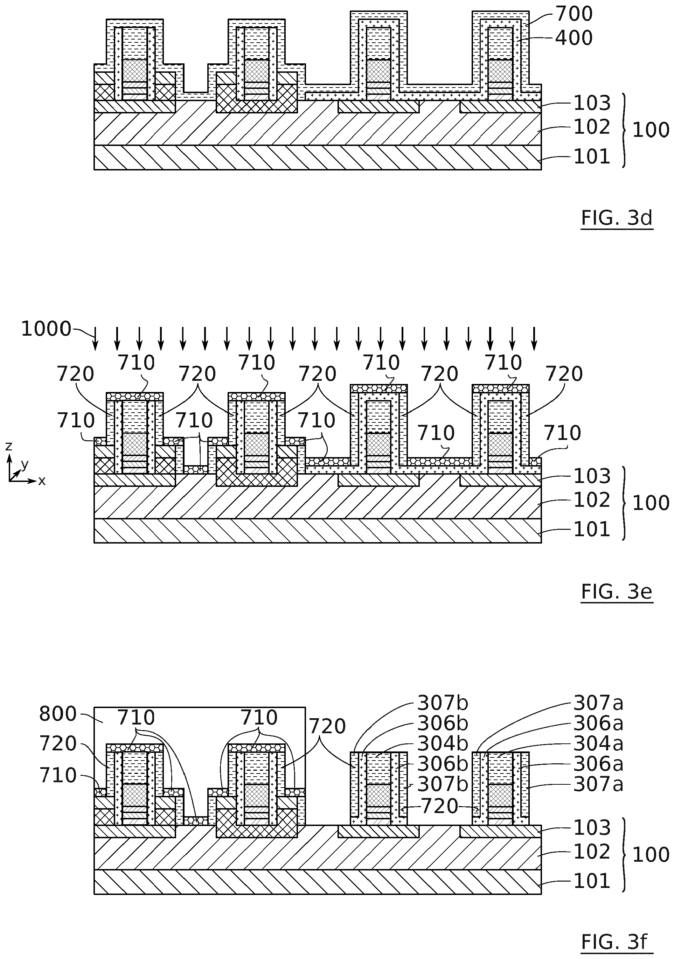

Dans la description qui suit, les épaisseurs sont généralement mesurées selon des directions perpendiculaires au plan de la face inférieure de la couche à base de nitrure de silicium ou d'un substrat sur lequel la couche inférieure est disposée. Ainsi, les épaisseurs sont généralement prises selon une direction verticale, correspondant à l'axe z du repère représenté en figure 3e. En revanche l'épaisseur d'une couche recouvrant un flanc d'un motif est prise selon une direction perpendiculaire à ce flanc. Ainsi si le flanc est vertical, l'épaisseur est alors prise selon une direction horizontale, correspondant à l'axe x du repère représenté en figure 3e.

Dans le cadre de la présente invention, on qualifie de résine un matériau organique ou organo-minéral pouvant être mis en forme par une exposition à un faisceau d'électrons, de photons ou de rayons X ou mécaniquement.

L'emploi du singulier pour certains éléments de l'invention ne signifie pas obligatoirement qu'un élément donné est présent de manière unique dans l'invention. Le mot « un » ou « une » ne signifie donc pas exclusivement respectivement « un seul » ou « une seule » à moins qu'il en soit disposé autrement.

Dans la présente invention des types de dopage seront indiqués. Ces dopages sont des exemples non limitatifs. L'invention couvre tous les modes de réalisation dans lesquels les dopages sont inversés. Ainsi, si un exemple de réalisation mentionne pour une première zone un dopage P et pour une deuxième zone un dopage N, la présente description décrit alors, implicitement au moins, l'exemple inverse dans lequel la première zone présente un dopage N et la deuxième zone un dopage P.

De manière conventionnelle, un dopage de type P est un dopage par des charges positives. Typiquement la teneur en espèce dopante est supérieure ou égale à 1 atome de l'espèce dopante pour moins de 1000 atomes du semi-conducteur et de préférence pour moins de 10 à 100 atomes du matériau formant la couche semi-conductrice. De même, un dopage N est un dopage par des charges négatives. Typiquement la teneur en espèce dopante est supérieure ou égale à 1 atome de l'espèce dopante pour moins de 1000 atomes du semi-conducteur et de préférence pour moins de 10 à 100 atomes du matériau formant la couche semi-conductrice.

Dans la présente demande de brevet, un dopage noté P englobe tous les dopages par porteurs de charges positives quelle que soit la teneur du dopage. Ainsi, un dopage P comprend les teneurs en dopage P+ et les teneurs en dopage P inférieures au dopage de type P+. De même, un dopage noté N englobe tous les dopages par porteurs de charges négatives quelle que soit la teneur du dopage. Ainsi, un dopage N comprend les teneurs en dopage N+ et les teneurs en dopage N inférieures au dopage de type N+.

On entend par un substrat, un film, une couche, « à base » d'un matériau A, un substrat, un film, une couche comprenant ce matériau A et éventuellement d'autres matériaux, par exemple des éléments dopants.

Le mot « diélectrique » qualifie un matériau dont la conductivité électrique est suffisamment faible dans l'application donnée pour servir d'isolant.

Dans le cadre de la présente invention, la constante diélectrique d'une couche se mesure par exemple par la méthode classique dite de la goutte de mercure.

Avant d'entamer une revue détaillée de modes de réalisation de l'invention, sont énoncées ci-après des caractéristiques optionnelles qui peuvent éventuellement être utilisées en association ou alternativement.

Selon un mode de réalisation, la couche à base de SiN est formée à une température supérieure ou égale à 500°C et de préférence supérieure ou égale à 550°C.

Il s'avère que le procédé selon l'invention est particulièrement avantageux lorsque la couche à base nitrure de silicium a été déposée à une température supérieure à 500°C et de préférence supérieure à 550°C. En effet, avec cette température de dépôt, une chimie fluorocarbonée additionnée de SiCl4 ou de SiF4 ne permettrait pas de graver la couche de nitrure de silicium.

Selon un mode de réalisation, la couche à base de SiN surmonte, de préférence en étant au contact de, une couche faite d'un matériau pris parmi:
- un matériau semiconducteur, de préférence pris parmi le silicium (Si), le germanium (Ge) et alliage de silicium et de germanium (SiGe),
- un oxyde de silicium (SiOx).

Selon un mode de réalisation, l'implantation est effectuée de manière à ce que les ions implantés soient répartis de manière ininterrompue depuis la surface de la couche à base de SiN et sur une profondeur inférieure ou égale à l'épaisseur de la couche à base de SiN, l'épaisseur étant prise selon une direction principale d'implantation.

Selon un mode de réalisation, les paramètres de l'implantation, en particulier l'énergie, la durée et la dose de l'implantation, sont prévus de sorte que l'au moins une zone modifiée s'étende sur une profondeur inférieure à l'épaisseur de la couche à base de SiN, l'épaisseur étant prise selon une direction principale (z) d'implantation.

Ainsi, une partie de l'épaisseur de la couche de nitrure de silicium n'est pas modifiée lors de l'implantation. À l'issue de l'étape de retrait, au niveau des zones modifiées, une partie seulement de l'épaisseur de la couche de nitrure de silicium est ainsi gravée.

Selon un mode de réalisation alternatif, les paramètres de l'implantation, en particulier l'énergie, la durée et la dose de l'implantation, sont prévus de sorte que l'au moins une zone modifiée s'étende sur une profondeur supérieure ou égale à l'épaisseur de la couche à base de SiN, l'épaisseur étant prise selon une direction principale (z) d'implantation.

Ainsi, toute l'épaisseur de la couche à base de nitrure de silicium est modifiée lors de l'implantation. À l'issue de l'étape de retrait, au niveau de l'au moins une zone modifiée, toute l'épaisseur de la couche de nitrure de silicium sera ainsi gravée.

Selon un mode de réalisation, la profondeur sur laquelle l'implantation est réalisée est comprise entre 1 nm et 30 nm et de préférence entre 1 nm et 10 nm.

Selon un mode de réalisation, la modification de la couche à base de SiN est effectuée sur une profondeur s'étendant depuis une surface de la couche à base de SiN et jusqu'à une portion au moins de l'épaisseur de la couche à base de SiN.

Les ions légers sont des ions à base d'hélium (He) et/ou des ions à base d'hydrogène (H).

Les ions à base d'hydrogène (H). sont de préférence pris parmi les ions suivants: H, H⁺, H₂⁺, H₃⁺.

Avantageusement, les ions à base d'hydrogène réduise les risques de pulvérisation et donc de gravure de la couche de SiN. On obtient alors un meilleur contrôle de la profondeur d'implantation.

Selon un mode de réalisation, ladite étape de gravure de l'au moins une zone modifiée est une étape de gravure plasma.

Selon un mode de réalisation, la couche à base de SiN est faite d'un matériau comprenant ou constituée de l'un des matériaux suivants: le SiN, le SiCN, le SiCBN.

De manière plus générale la couche à base de SiN est faite d'un matériau comprenant les espèces Si, N et éventuellement d'autres espèces à l'exception de l'oxygène.

Selon un mode de réalisation, l'implantation est réalisée de manière anisotrope, selon au moins une direction principale (z) d'implantation sensiblement perpendiculaire au plan (xy) dans lequel s'étend la couche à base de SiN ou un substrat sur lequel est disposé la couche à base de SiN.

Selon un mode de réalisation, l'implantation d'ions à base d'hydrogène ou d'hélium est réalisée à partir d'un plasma.

Selon un mode de réalisation, l'implantation dans la couche à base de SiN est effectuée à travers un masque, comportant de préférence au moins un motif de résine

Selon un mode de réalisation, on effectue plusieurs cycles comprenant chacun une implantation dans la couche à base de SiN et un retrait de ladite au moins une zone modifiée par gravure sélective de ladite au moins une zone modifiée par rapport au moins à une portion non modifiée de la couche à base de SiN.

Selon un mode de réalisation, les étapes de modification et de retrait de la couche à base de SiN sont réalisées dans un même réacteur plasma.

Cela permet de simplifier considérablement le procédé est d'augmenter les cadences de production.

Selon un mode de réalisation, l'implantation d'ions à base d'hydrogène (ou hélium) et l'étape de gravure sont réalisées dans un plasma à couplage inductif (ICP) ou un plasma à couplage capacitif (CCP) ou encore un plasma par immersion.

Selon un mode de réalisation, la couche à base de SiN recouvre au moins un motif présentant des flancs et l'implantation desdits ions est réalisée de manière anisotrope selon une direction principale (z) d'implantation parallèle auxdits flancs.

Selon un mode de réalisation, les flancs sont sensiblement plans. Selon un mode de réalisation, les flancs peuvent être formés par des espaceurs du motif.

Selon un mode de réalisation, la modification de la couche à base de SiN est effectuée de préférence sur une profondeur correspondant à toute l'épaisseur de la couche à base de SiN au niveau de portions de la couche à base de SiN ne recouvrant pas les flancs et de préférence perpendiculaires aux flancs, de manière à ce que le retrait de ladite au moins une zone modifiée retire toute la couche à base de SiN en dehors des flancs de l'au moins un motif et laisse en place au moins une partie de la couche à base de SiN recouvrant les flancs de l'au moins un motif.

Selon un mode de réalisation, l'au moins un motif est ou comprend une grille d'un transistor située au-dessus d'une couche en un matériau semi-conducteur. L'étape de modification est effectuée de manière à implanter les ions légers sur toute l'épaisseur de la couche à base de SiN en dehors des flancs de la grille et éventuellement sur une portion de l'épaisseur de la couche de nitrure de silicium située sur des flancs de la grille. Les étapes d'implantation et de retrait de ladite au moins une zone modifiée sont effectuées de manière à graver ladite au moins une zone modifiée sélectivement au matériau semi-conducteur et au nitrure de silicium non modifié.

Selon un mode de réalisation, les étapes d'implantation et de retrait de ladite au moins une zone modifiée sont effectuées de manière à conserver sur les flancs de l'au moins un motif des zones non modifiées formant des espaceurs de grille.

Le retrait de l'au moins une zone modifiée comprend au moins une étape de gravure par plasma de l'au moins une zone modifiée utilisant une chimie comprenant au moins:
∘ au moins un composé pris parmi les composés fluorocarbonés (CₓF_{z}) ou les composés hydrofluorocarbonés (CₓH_{y}F_{z}), et
∘ au moins un composé pris parmi le Si_{w}Cl(2_{w}+2) et le Si_{w}F(2_{w}+2), et
∘ au moins un composé pris parmi l'oxygène ou l'azote.
Selon un mode de réalisation, 0.2 ≤R' = A / { B + C') ≤ 2 et de préférence 0.5≤R' = A / { B + C') ≤ 1.5. Selon un mode de réalisation 0.75 ≤R' = A / { B + C') ≤ 1.25, et avantageusement 0.9 ≤R' = A/{ B + C') ≤ 1.1, avec :
A= débit de O2 ou de N2 ou de O2+N2.
B= débit de l'au moins un composé pris parmi les composés fluorocarbonés (CₓF_{z}) ou les composés hydrofluorocarbonés (CₓH_{y}F_{z}),
C= débit de l'au moins un composé pris parmi le Si_{w}Cl(2_{w}+2) et de préférence = SiCl4.
Selon un mode de réalisation, l'au moins un composé pris parmi le Si_{w}Cl(2_{w}+2) est le SiCl4.Ce composé offre une sélectivité de gravure particulièrement élevée.

Selon un mode de réalisation,
∘ avant les étapes de modification de la couche à base de SiN et de retrait de l'au moins une zone modifiée (710), on effectue l'étape suivante:
   - une étape de fourniture d'un substrat surmonté d'au moins un premier motif de grille et d'au moins un deuxième motif de grille, la couche à base de SiN recouvrant les premier et deuxième motifs de grille, lesdits motifs présentant des flancs ;
∘ l'implantation des ions légers est réalisée de manière à former des zones modifiées de la couche à base de SiN en dehors des flancs et à conserver une portion au moins de l'épaisseur de la couche à base de SiN sur lesdits flancs, lesdites portions définissant des zones non modifiées ;
∘ après l'étape de modification de la couche à base de SiN et avant l'étape de retrait de l'au moins une zone modifiée, on effectue les étapes suivantes :
   - masquage du premier motif de grille par une couche de masquage ;
   - retrait des zones modifiées de la couche à base de SiN située sur le deuxième motif de grille sélectivement aux zones non modifiées situées sur le deuxième motif de grille ;
   - retrait de la couche de masquage de manière à mettre à nu la couche à base de SiN située sur le premier motif de grille.

Selon un mode de réalisation, le premier motif de grille est un premier empilement de grille d'un transistor d'un type N ou P et le deuxième motif de grille est un deuxième empilement de grille d'un transistor d'un type différent du type du premier empilement de grille.

La présente invention a pour avantage de proposer une solution simple et efficace pour intégrer de manière reproductible et simple, sur un même substrat, des transistors présentant des caractéristiques différentes, par exemple des transistors de type N et des transistors de type P.

Selon un mode de réalisation, le substrat est surmonté d'une pluralité de premiers motifs de grille et d'une pluralité de deuxièmes motifs de grille, l'une parmi la pluralité de premiers motifs de grille et la pluralité de deuxièmes motifs de grille comprend au moins un premier type d'empilement de grille et un deuxième type d'empilement de grille chacun des premier et deuxième types d'empilements de grille comprenant au moins une couche isolante, typiquement un oxyde de grille. L'épaisseur de la couche isolante du premier type d'empilement de grille diffère de l'épaisseur de la couche isolante du deuxième type d'empilement de grille.

Ainsi, sur un même substrat élaboré, on peut réaliser des transistors d'un premier type présentant une caractéristique différente de celle d'un deuxième type de transistor. Par exemple, on peut réaliser, sur un même substrat, des transistors d'un premier type présentant une première épaisseur d'oxyde de grille et des transistors d'un second type présentant une deuxième épaisseur d'oxyde de grille supérieure à la première épaisseur afin de fonctionner à des tensions supérieures.

Afin de limiter la complexité du procédé, de nombreuses étapes sont communes à la réalisation des deux types de transistors dont notamment la réalisation de la couche métallique, la grille en polysilicium, les espaceurs, les sources et drains.

La présente invention a pour avantage de proposer une solution simple et efficace pour intégrer de manière reproductible et simple, sur un même substrat, des transistors présentant des caractéristiques différentes, par exemple des oxydes de grille dont les épaisseurs sont différentes.

Selon un mode de réalisation, l'épaisseur de ladite couche isolante du premier empilement est comprise entre 0 et 3 nm (10⁻⁹ mètres) et de préférence entre 0 et 1,5 nm.

Selon un mode de réalisation, l'épaisseur de ladite couche isolante du deuxième empilement est comprise entre 1,5 et 8 nm, de préférence entre 2 et 6 nm et de préférence entre 2 et 3,5 nm.

Selon un mode de réalisation, le premier motif de grille est un motif sacrificiel. Le deuxième motif est un motif sacrificiel. Le procédé comprend, après ladite étape de retrait des zones modifiées de la couche de nitrure, une étape de remplacement des premier et deuxième motifs sacrificiels par des motifs formant respectivement un premier empilement de grille et un deuxième empilement de grille.

Selon un mode de réalisation, chacun des premier et deuxième empilements de grille comprend au moins une couche isolante, typiquement un oxyde de grille.

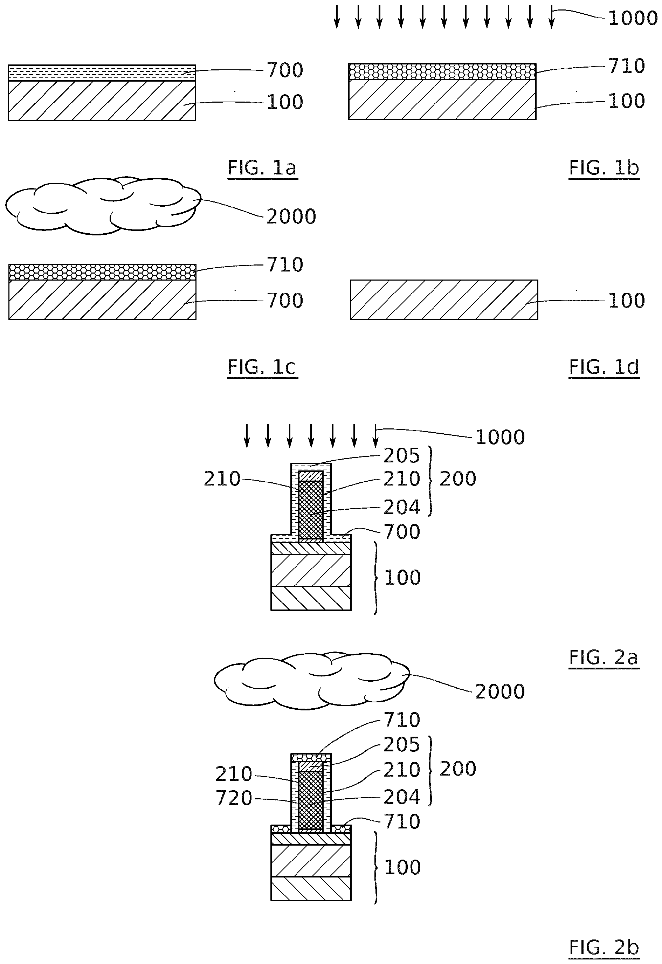

Un premier mode de réalisation de la présente invention va être décrit en référence aux figures 1a à 1d. Toutes les caractéristiques, étapes et avantages décrits en référence à ces figures 1a à 1d sont applicables à tous les autres modes de réalisation de l'invention et notamment à ceux décrits sur les autres figures.

La figure 1a illustre une première étape qui consiste à fournir un empilement de couches comprenant au moins un substrat 100 surmonté d'une couche à base de nitrure de silicium 700.

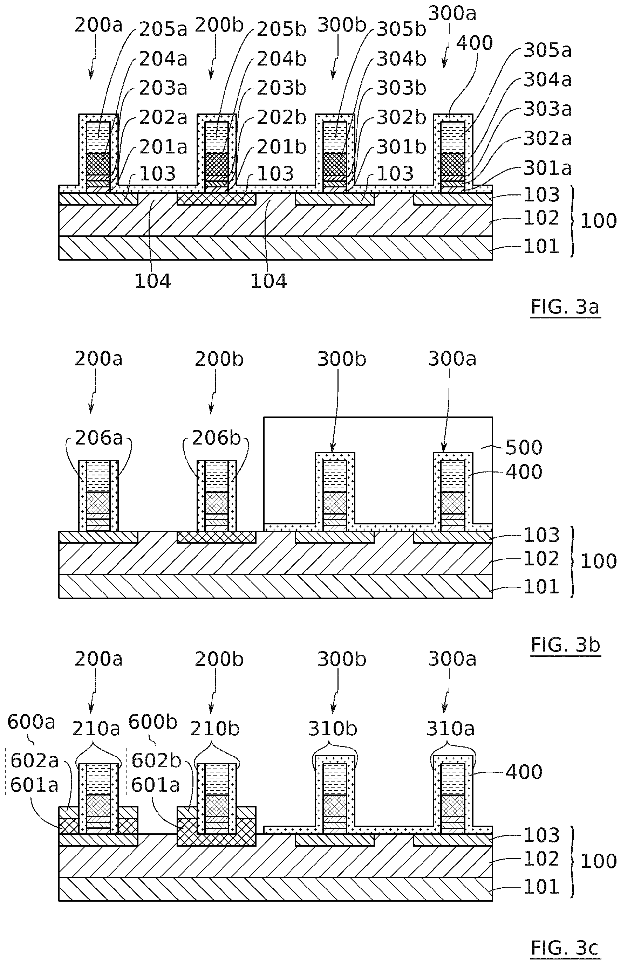

Le substrat 100 peut être un substrat monocouche massif comme illustré en figure 1. Alternativement, le substrat 100 peut être formé de plusieurs couches superposées comme illustré sur les exemples des figures 2a et 2b et 3a à 3h. Le substrat 100, au niveau de son interface avec la couche à base de nitrure de silicium est par exemple en un matériau semi-conducteur de préférence pris parmi le silicium (Si), le germanium (Ge) ou un alliage de silicium et de germanium (SiGe). Alternativement, le substrat 100 au niveau de cette interface est fait d'un matériau isolant tel que l'oxyde de silicium (SiOx, x étant un entier).

La couche à base de nitrure de silicium 700 est faite d'un matériau comprenant ou constituée de l'un des matériaux suivants: le SiN, le SiCN, le SiCBN. De manière plus générale la couche 700 à base de SiN est faite d'un matériau comprenant les espèces Si, N et éventuellement d'autres espèces à l'exception de l'oxygène.

Cette couche est par exemple formée à une température de dépôt supérieur ou égal à 450°C de préférence supérieure ou égale à 550°C.

La gravure de la couche 700 à base de SiN comprend les étapes principales suivantes :
- une modification de la couche 700 à base de nitrure de silicium de manière à former au moins une zone modifiée 710. La modification comprend au moins une implantation 1000 d'ions légers dans la couche 700 à base de nitrure de silicium.
- Le retrait de l'au moins une zone modifiée 710 par gravure de l'au moins une zone modifiée 710 à l'aide d'une chimie comprenant au moins :
   ∘ au moins un composé pris parmi les fluorocarbures (CₓFz) et les hydrofluorocarbures (CₓH_{y}F_{z}), et
   ∘ au moins un composé pris parmi Si_{w}Cl(2_{w}+2) et Si_{w}F(2_{w}+2), x, y, z et w étant des entiers. De préférence w = 1 ou w = 2. La chimie comprend également au moins un composé pris parmi l'oxygène et l'azote.

Comme illustré clairement en figure 1b, 1c, 2a, 2b, 3e, 3h et 4 notamment, l'étape de modification par implantation est effectuée avant l'étape de retrait de l'au moins une zone modifiée de la couche à base de nitrure de silicium. Ces étapes sont donc effectuées successivement.

De préférence la modification par implantation et le retrait de la couche 700 sont effectués dans le même réacteur.

Ces étapes vont être détaillées en référence aux figures 1b à 1d.

### Modification par implantation

La figure 1b illustre une étape de modification d'une partie au moins de la couche à base de nitrure 700. Cette modification consiste à implanter dans la couche à base de nitrure 700 des ions légers. Les ions légers sont de préférence pris parmi les ions suivants: H, H⁺, H₂⁺, H₃⁺, He⁺.

Les ions à base d'hydrogène proviennent par exemple d'un plasma de H2. Ce gaz permet d'éviter les risques de pulvérisation de la couche à base de nitrure 700. Alternativement, les ions à base d'hydrogène peuvent provenir des gaz suivants H₂, NH₃, HBr, ou d'un mélange d'un gaz à base de H avec un gaz inerte, par exemple Ar ou He. Cependant dans ce dernier cas les risques de pulvérisation physique de la couche 700 sont plus importants.

De préférence, l'implantation 1000 est effectuée de manière à modifier la structure de la couche à base de nitrure de silicium 700 dans les zones implantées, sans entraîner de pulvérisation de cette couche.

Avantageusement, l'implantation 1000 est effectuée de manière à ce que les ions implantés soient répartis de manière ininterrompue depuis la surface de la couche 700 à base de nitrure de silicium et jusqu'à une profondeur souhaitée. Cette répartition ne présente pas de discontinuité. Il n'y a donc pas de couches où les espèces implantées sont absentes entre la surface de la couche 700 à base de nitrure de silicium et la profondeur maximale d'implantation. Cette répartition peut être homogène ou non homogène. Typiquement, cette répartition va décroissant depuis la surface de la couche 700 à base de nitrure de silicium et jusqu'à ladite profondeur.

Selon un mode de réalisation particulièrement avantageux, l'implantation 1000 est réalisée à partir d'un plasma.

L'implantation 1000 par plasma a pour avantage de permettre une implantation 1000 de manière continue dans un volume s'étendant dès la surface de la couche implantée.

En outre, l'utilisation d'un plasma permet une implantation 1000 à des profondeurs plus faibles que les profondeurs minimales que l'on peut obtenir avec des implanteurs. Ainsi, une implantation 1000 par plasma permet d'implanter efficacement et de manière relativement homogène ou tout au moins de manière continue des épaisseurs fines que l'on peut ensuite retirer par une gravure sélective. Cette continuité d'implantation 1000 depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation 1000 vis à vis des autres couches est effective dès le début de la gravure de la couche implantée. L'implantation 1000 par plasma permet ainsi un contrôle significativement amélioré de la précision de gravure.

L'implantation 1000 d'un plasma permet typiquement d'implanter, puis de retirer, des épaisseurs s'étendant depuis la surface de la couche implantée et sur une profondeur allant de 0 nm à 100 nm. Les implanteurs classiques, permettent une implantation 1000 dans un volume compris entre 30 nm et plusieurs centaines de nanomètres. En revanche, les implanteurs classiques ne permettent pas d'implanter les espèces entre la surface de la couche à implanter et une profondeur de 30 nm.

L'utilisation d'un plasma pour modifier la couche à retirer est donc particulièrement avantageuse lorsqu'il s'agit de retirer une fine épaisseur, typiquement comprise entre 1 et 10 nm et plus généralement entre 1 et 30 nm.

L'étape de modification réalisée à partir d'un plasma modifie la couche 700 à base de nitrure de silicium de manière continue depuis la surface de cette couche et sur une épaisseur comprise entre 1 nm et 30nm et de préférence entre 1 nm et 10 nm.

Selon un mode de réalisation particulièrement avantageux, l'implantation 1000 et le retrait de la couche 700 à base de nitrure de silicium (étape qui sera décrite en détail par la suite) sont réalisées dans un même réacteur plasma. Une modification de la couche à retirer réalisée par une implantation 1000 par plasma permet ainsi d'effectuer la modification de la couche et la gravure dans une même chambre ce qui est très avantageux en termes de simplification, de temps et de coût du procédé.

Avantageusement, cette implantation 1000 d'ions ne grave pas le matériau n'entraînant pas de re-depôt du matériau sur les flancs des motifs ou sur les parois du réacteur permettant, d'une part, d'obtenir un meilleur contrôle des dimensions critiques des motifs gravés et, d'autre part, d'acquérir une indépendance de la gravure vis-à-vis du conditionnement des parois du réacteur.

Avantageusement, l'obtention précise d'une profondeur souhaitée d'implantation, par contrôle de l'énergie des ions et de leur dose, n'entraîne pas la formation d'une couche réactive comme dans les procédés standards de gravure plasma évitant ainsi de nombreux inconvénients.

Avantageusement, les paramètres d'implantation, en particulier l'énergie communiquée aux ions, la durée et la dose d'implantation 1000 sont prévus de sorte que les zones modifiées 710 par implantations puisse être gravées sélectivement par rapport à la au moins une couche sous-jacente. Ces paramètres sont également réglés de manière à ce que les zones modifiées 710 puissent être gravées sélectivement par rapport aux zones non modifiée de la couche 700 à base de nitrure de silicium.

Avantageusement, les ions sont choisis de sorte que les zones modifiées 710 soient susceptibles d'être gravées sélectivement vis-à-vis de la ou des couches qui leur sont sous-jacentes.

Selon un mode de réalisation, l'implantation 1000 est réalisée de manière anisotrope, selon au moins une direction d'implantation 1000 sensiblement perpendiculaire au plan dans lequel s'étend la couche 700 à base de nitrure de silicium ou le substrat 100.

Selon un mode de réalisation, la modification de la couche 700 à base de nitrure de silicium est effectuée sur une profondeur correspondant à toute l'épaisseur de la couche 700 à base de nitrure de silicium, de manière à ce que le retrait de la zone modifiée 710 retire toute la couche 700 à base de nitrure de silicium. C'est cet exemple qui est illustré en figure 1b.

Selon un autre mode de réalisation, la modification de la couche 700 à base de nitrure de silicium est effectuée sur une profondeur correspondant à une portion seulement de l'épaisseur de la couche 700 à base de nitrure de silicium, de manière à ce que le retrait de la zone modifiée 710 retire une portion seulement de l'épaisseur de la couche 700 à base de nitrure de silicium.

L'étape de modification de la couche 700 comprend par exemple la formation d'un plasma comprenant les ions légers. La cible à graver, c'est-à-dire la couche 700 surmontant le substrat 100, est placée dans le plasma et est bombardée par les ions qui y sont produits. Plusieurs options pour la formation du plasma sont possibles :
- On utilise une chambre de gravure plasma standard dans laquelle il est possible de contrôler l'énergie appliquée aux ions. On crée alors un plasma à faible densité de type RIE, acronyme de l'anglais « reactive ion etching », c'est-à-dire « gravure ionique réactive ». On peut aussi former un plasma à haute densité dans un graveur de type ICP, acronyme de l'anglais « Inductive Coupled Plasma », c'est-à-dire « plasma à couplage inductif », appareillage dans lequel le champ radiofréquence destiné à former le plasma est produit par une antenne externe à la chambre. On peut encore obtenir la modification de la couche 700 à partir d'un plasma à très haute densité obtenu dans un appareillage de type ECR, acronyme de l'anglais « Electronic Cyclotronic Resonance », c'est-à-dire « résonance cyclotron électronique ». Dans ce type d'appareillage, le plasma est produit en superposant un champ magnétique statique et un champ électromagnétique à haute fréquence à la fréquence de résonance du cyclotron ou mouvement circulaire d'électrons qui est produit.

- Une autre option consiste à utiliser un plasma dit en immersion de type à « couplage capacitif » ou CCP, acronyme de l'anglais « Capacitive Coupled Plasma » où on applique entre deux électrodes une tension continue ou pulsée élevée. La cible à implanter est placée sur l'une des électrodes, généralement la cathode, et est donc polarisée négativement. Ce type d'implantation est particulièrement efficace.

Alternativement, on procède à une implantation 1000 directe des ions, sans que la cible soit placée dans un plasma. Plusieurs options sont possibles :
- On utilise des équipements de type IBE, acronyme de l'anglais « ion beam etch » c'est-à-dire « gravure par faisceau d'ions », dans lesquels, de manière conventionnelle, on communique à un faisceau d'ions une énergie suffisante pour graver par pulvérisation le matériau bombardé. Dans le cadre de l'invention, le bombardement est donc utilisé pour modifier la couche 700 sans toutefois la graver. Il existe des variantes de ces équipements dans lesquels on pratique une gravure dite RIBE c'est-à-dire une gravure ionique réactive qui est similaire sauf que des ions réactifs sont incorporés dans le faisceau d'ions de gravure. Dans une autre variante connue sous le nom de gravure par faisceau d'ions assistée chimiquement (CAIBE), les espèces réactives sont introduites dans le processus indépendamment du faisceau d'ions.
- On peut aussi utiliser un implanteur standard du type de ceux servant à implanter des espèces dopantes dans un matériau semi-conducteur.

L'implantation 1000 peut être effectuée pleine plaque et sans masque comme illustré en figure 1b.

Alternativement cette implantation 1000 peut être effectuée à travers un masque pour que seules certaines zones de la couche à base de nitrure de silicium 700 soient implantées. L'implantation 1000 est alors effectuée selon une direction privilégiée qui est perpendiculaire au plan dans lequel le masque s'étend. De préférence, le masque est un masque dur. Le masque présente des ouvertures définissant des motifs. De préférence, l'implantation 1000 est effectuée pleine plaque, c'est-à-dire dans les ouvertures du masque et hors de ces ouvertures.

### Retrait des zones modifiées

Les figures 1c et 1d illustrent l'étape de retrait sélectif de l'au moins une zone modifiée 710 par l'implantation 1000.

Pour ce retrait, on grave l'au moins une zone modifiée 710 à l'aide d'une chimie comprenant:
∘ au moins un composé pris parmi les composés fluorocarbonés (CₓFz) et les composés hydrofluorocarbonés (CₓH_{y}F_{z}), et
∘ au moins un composé pris parmi Si_{w}Cl(2_{w}+2) et Si_{w}F(2_{w}+2), x, y, z et w étant des entiers. De préférence w = 1 ou w = 2. et au moins un composé pris parmi l'oxygène et l'azote.

Optionnellement, des cycles comprenant chacun au moins l'étape d'implantation et l'étape de retrait sont répétés autant de fois que nécessaire pour graver complètement la couche 700, ou atteindre la profondeur de gravure souhaitée, si celle-ci ne peut être obtenue en une seule fois.

De préférence, l'étape de retrait des zones modifiées 710 de la couche 700 est effectuée par gravure sèche dans un plasma 2000 formé dans une enceinte confinée à partir des espèces indiquées ci-dessus.

Un deuxième mode de réalisation va maintenant être décrit en référence aux figures 2a à 2b.

Dans ce mode de réalisation, le substrat 100 comprend un empilement de couches. Un motif 200 est formé sur le substrat 100. Ce motif 200 est par exemple un empilement de grille de transistor. Typiquement cet empilement comprend au moins successivement depuis le substrat 100 : une couche isolante formant un oxyde de grille, une grille 204 et un masque dur 205. Les différentes couches formant un tel motif seront détaillées en référence à la figure 3a.

Préalablement à l'étape 2a, on dépose une couche 700 à base de nitrure de silicium sur le motif 200 et sur le substrat 100. Ce dépôt est conforme. L'épaisseur de la couche 700 est par conséquent homogène sur les flancs 210 du motif 200 ainsi que sur le dessus du motif 200 et en dehors du motif 200.

L'étape 2a illustre la modification de la couche 700 à base de nitrure de silicium par l'implantation 1000 d'ions légers. L'implantation est anisotrope. La direction principale d'implantation 1000 est perpendiculaire au plan principal dans lequel s'étend le substrat 100 est parallèle aux flancs 210 du motif 200.

Ainsi, comme illustré en figure 2b, les flancs 210 du motif 200 ne sont pas modifiés ou sont modifiés sur une épaisseur bien plus faible que les zones situées en dehors du motif et sur le dessus du motif 200. Les zones modifiées sur une forte épaisseur sont référencées 710 et les zones non modifiées ou modifiées sur une plus faible épaisseur sont référencées 720.

La figure 2b illustre également l'étape de gravure des zones modifiées 710 à l'aide d'un plasma 2000 comprenant au moins un composé fluorocarboné (CₓF_{z}) ou hydrofluorocarboné (CₓH_{y}F_{z}) additionné d'au moins un composé pris parmi les Si_{w}Cl(2_{w}+2) et les Si_{w}F(2_{w}+2).

À l'issue de cette étape de gravure, les zones 710 sont retirées et les zones 720 sont conservées. Ces dernières forment donc des espaceurs sur les flancs 210 du motif 200.

Selon ce mode de réalisation la modification de la couche 700 à base de nitrure de silicium est effectuée sur une profondeur correspondant à toute l'épaisseur de la couche 700 à base de nitrure de silicium prise selon une direction perpendiculaire à la direction de l'implantation 1000 anisotrope, de manière à ce que le retrait du film retire toute la couche 700 à base de nitrure de silicium en dehors des flancs des motifs et laisse en place au moins une partie de la couche 700 à base de nitrure de silicium recouvrant les flancs des motifs. Le procédé selon l'invention offre ainsi une solution fiable et très précise pour former des espaceurs d'une grille de transistor.

On obtient ainsi des espaceurs en nitrure de silicium dont les épaisseurs sont contrôlées avec précision et sans dégrader le substrat 100 sous-jacent.

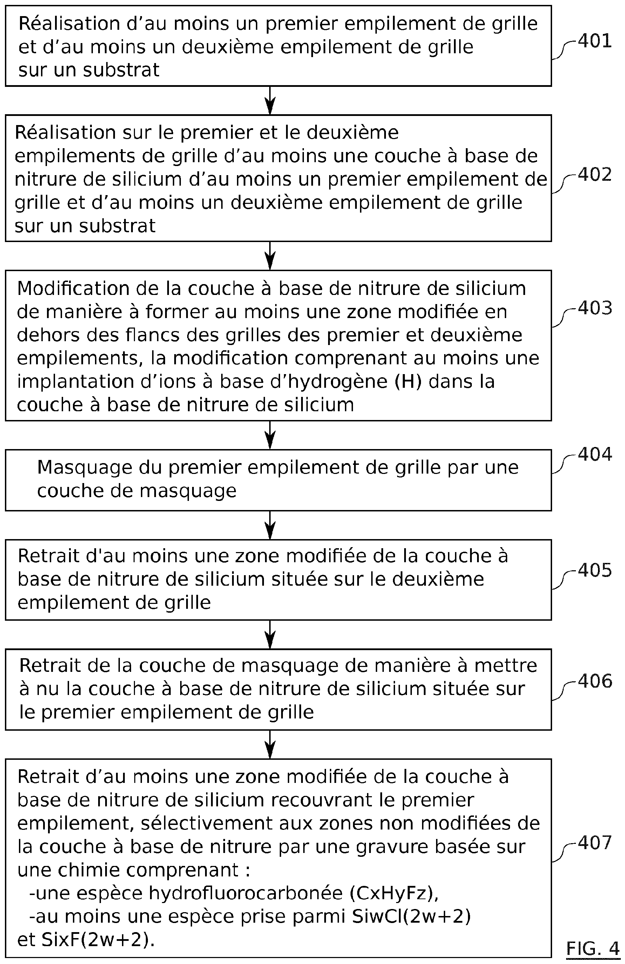

En référence aux figures 3a à 3h et 4, un troisième mode de réalisation de l'invention va maintenant être décrit.

La figure 3a illustre une structure à partir de laquelle les étapes du procédé selon l'invention sont mises en oeuvre. Cette structure comprend des transistors en cours de formation.

Cette structure comprend :
- un substrat élaboré 100 de type semi-conducteur sur isolant (SOI). Sur l'exemple illustré ce substrat élaboré comprend successivement une couche de support 101 ; par exemple en silicium monocristallin, polycristallin ou amorphe; une couche isolante 102, habituellement qualifiée d'oxyde enterré (BOX pour « Buried Oxide » en anglais) et une couche active 103 semi-conductrice destinée à former un canal de conduction d'un transistor. Cette dernière est par exemple en silicium (Si), en germanium (Ge) ou en silicium-germanium (SiGe), de préférence monocristallin.
- des motifs 200a, 200b, 300a, 300b de grille. Comme illustré sur les figures 3a à 3h, la couche semi conductrice 103 est discontinue pour former des portions disjointes, chaque portion étant située sous un motif 200a, 200b, 300a, 300b.

Dans l'exemple illustré, non limitatif, les motifs 200a, 200b, 300a, 300b, de grille forment chacun un empilement de plusieurs couches. Ces motifs 200a, 200b, 300a, 300b sont destinés à être conservés dans les transistors finaux (procédé de type gate first). Selon un mode de réalisation alternatif non illustré, les motifs 200a, 200b, 300a, 300b de grille sont des motifs sacrificiels qui sont destinés à être retirés après réalisation des espaceurs, puis à être remplacés par une autre grille formant de préférence un empilement (procédé de type gate last). L'invention couvre ce mode de réalisation alternatif.

Dans la suite de la description, qui illustre un mode de réalisation de type gate first en référence aux figures, on utilisera aussi bien le terme empilement que motif.

Typiquement et comme pour le mode de réalisation des figures 2a à 2b les empilements de grille comprennent chacun au moins une grille 204a, 204b, 304a, 304b habituellement en silicium polycristallin ou en métal et une couche isolante habituellement qualifiée d'oxyde de grille 201a, 201b, 301a, 301b située sous la grille et au travers de laquelle un champ électrique va pouvoir se développer pour créer un canal de conduction sous-jacent entre source et drain quand une tension suffisante est appliquée sur la grille 204a, 204b, 304a, 304b.

De manière préférée, l'empilement de grille comprend également :
- une couche métallique souvent qualifiée de grille métallique 203a, 203b, 303a, 303b et située entre la grille 204a, 204b, 304a, 304b et l'oxyde de grille 201a, 201b, 301a, 301b;
- une couche diélectrique 202a, 202b, 302a, 302b, dite « high-k », c'est-à-dire faite d'un matériau à haute permittivité. Cette couche est située entre l'oxyde de grille 201a, 201b, 301a, 301b et la grille métallique 203a, 203b, 303a, 303b.
- un masque dur 205a, 205b, 305a, 305b de protection qui sera enlevé ultérieurement pour permettre la reprise de contact sur la grille 204a, 204b, 304a, 304b. Ce masque dur 205a, 205b, 305a, 305b, qui reste en place après gravure de la grille 204a, 204b, 304a, 304b, est typiquement fait de SiO2 ou de nitrure de silicium (SiN). Son rôle est de protéger le sommet de la grille 204a, 204b, 304a, 304b de tout dommage lors de la réalisation des étapes suivantes et notamment celles de gravure des espaceurs. On peut trouver une fine couche d'oxyde entre le silicium polycristallin de la grille et le masque dur nitrure.

De préférence, la couche isolante d'oxyde de grille 201a, 201b, 301a, 301b est disposée au contact de la couche active 103 formant le canal de conduction et au contact de la couche à haute permittivité 202a, 202b, 302a, 302b. De préférence, la couche métallique 203a, 203b, 303a, 303b est disposée au contact de la couche à haute permittivité 202a, 202b, 302a, 302b et au contact de la grille 204a, 204b, 304a, 304b. Selon un autre mode de réalisation la couche métallique 203a, 203b, 303a, 303b et/ou la couche à haute permittivité 202a, 202b, 302a, 302b sont absentes. Selon un autre mode de réalisation, le masque dur 205a, 205b, 305a, 305b est formée en nitrure de silicium (SiN).

Un même substrat élaboré 100 supporte une pluralité de transistors et donc d'empilements de grille. Pour certaines applications, il est nécessaire d'avoir des transistors dont les propriétés sont différentes. Ainsi, certains transistors sont de type P (200a, 200b) et d'autres sont de type N (300a, 300b). Par ailleurs, certains transistors doivent présenter un oxyde de grille 201a, 301a dont l'épaisseur est plus importante que celle de l'oxyde de grille 201b, 301b d'autres transistors.

A titre d'exemple non limitatif, on peut ainsi avoir sur un même substrat élaboré 100 :
- des transistors dont l'oxyde de grille présente une épaisseur comprise entre 0 et 1,5 nm. Ces transistors sont connus pour fonctionner à une tension Vdd comprise entre 0,8V et 1V. Ces transistors sont parfois qualifiés de SG ou de GO1.

L'épaisseur des espaceurs est mesurée perpendiculairement au plan contenant les flancs des grilles, i.e. dans cet exemple, selon une direction parallèle au plan principal dans lequel le substrat 100 s'étend. Cette épaisseur est donc mesurée horizontalement sur les figures.
- des transistors dont l'oxyde de grille présente une épaisseur comprise entre 2 et 5 nm, et plus souvent entre 2 et 3,5 nm. Ces transistors sont connus pour fonctionner à une tension Vdd comprise entre 1,5V et 3,5V. Ainsi la tension de claquage pour ces transistors est plus élevée que la tension maximale appliquée à l'oxyde de grille. Ces transistors sont parfois qualifiés de EG ou GO2.
- des transistors dont l'oxyde de grille présente une épaisseur comprise entre 3 et 6 nm sont connus pour fonctionner à une tension Vdd supérieure à 3V. Ainsi la tension de claquage pour ces transistors est plus élevée que la tension maximale appliquée à l'oxyde de grille. Ces transistors sont parfois qualifiés de ZG ou GO3.

La structure illustrée en figure 3a montre également la présence de tranchée d'isolation 104 traversant toute la couche active 103 pour isoler deux transistors adjacents. Ces tranchées d'isolation 104 s'étendent à travers toute l'épaisseur de la couche active 103 et jusque dans la couche de support 101. Ces tranchées d'isolation sont typiquement réalisées en oxyde, par exemple en SiO2.

La structure illustrée en figure 3a montre également la présence d'au moins une couche de protection 400 destinée à former des espaceurs 206a, 206b sur les flancs des grilles 204a, 204b, 304a, 304b. Sur l'exemple illustré il n'y a qu'une seule couche de protection 400. Selon un mode de réalisation alternatif il y a plusieurs couches protection 400.

Comme illustré en figure 3a cette couche de protection 400 est déposée de manière conforme sur les empilements 200a, 200b, 300a, 300b. Cette couche de protection 400 présente par exemple une épaisseur comprise entre 3 et 10 nm sans que cela soit limitatif et de préférence de l'ordre de 4 à 8 nm. Elle est par exemple en un matériau à faible constante diélectrique (k inférieure à 7) tel que le SiCBN. Elle est de préférence déposée à une température supérieure ou égale à 550 °C.

Alternativement, cette couche de protection 400 peut être faite de l'un des matériaux suivants :SiN, SiCO ou SiOCN.

De manière générale cette couche de protection 400 est formée dans un matériau à faible constante diélectrique, plus précisément un matériau dont la constante diélectrique k est inférieure à 7.

La figure 3b illustre une étape suivante au cours de laquelle on forme une couche de masquage 500 pour recouvrir entièrement les deuxièmes empilements 300a, 300b de grille, c'est-à-dire dans ce cas les empilements destinés à former des transistors de type N. Les empilements 200a, 200b destinés à former des transistors de type P ne sont pas recouverts par la couche de masquage 500. Selon un mode de régulation alternatif, les empilements 200a, 200b destinés à former des transistors de type P sont masqués lors de cette étape et les empilements 300a, 300b destinés à former des transistors de type N ne sont pas recouverts.

Cette couche de masquage 500 est typiquement une couche de résine, déposée pleine plaque, puis ouverte au niveau des deuxièmes empilements 300a, 300b par l'une des techniques conventionnelles de lithographie.

L'étape suivante, également illustrée en figure 3b, vise à conserver la couche de protection 400 qui recouvre les flancs des premiers empilements 200a, 200b et à retirer cette couche 400 en dehors des premiers empilements 200a, 200b de grille. Au niveau des flancs des premiers empilements 200a, 200b la couche de protection 400 forme ainsi des espaceurs 206a, 206b.

De préférence pour effectuer cette gravure anisotrope de la couche de protection 400 sélectivement à la couche de l'empilement de grille 200a, 200b, à la couche semi conductrice 103 et à la couche isolante 102, on effectue une gravure plasma lisant une chimie fluorocarbonée. Ce type de chimie largement connu de l'homme du métier. On pourra par exemple utiliser une chimie à base de CH3F/O2/He.

Il s'agit donc d'une gravure anisotrope effectuée selon une direction privilégiée z qui est perpendiculaire au plan principal xy dans lequel s'étend le substrat 100.

Les figures 3a à 3c correspondent à l'étape 401 de la figure 4.

De préférence, la gravure anisotrope consomme toute la couche de protection 400 sur le sommet des premiers empilements 200a, 200b et entre ces derniers.

Par ailleurs les deuxièmes empilements 300a, 300b, c'est-à-dire les zones de type N, sont protégés par la couche de masquage 500 et demeurent en place.

Comme illustré en figure 3c, la couche de masquage 500 est ensuite retirée. Naturellement, ce retrait est sélectif du matériau de la couche de protection 400 afin de conserver cette dernière sur le premier empilement 200a, 200b. Lorsque cette couche de masquage 500 est une résine photosensible, elle est par exemple retirée dans un réacteur à couplage capacitif, ou à couplage inductif ou à micro-ondes en utilisant une chimie oxydante ou réductrice. Par exemple, on peut injecter un mélange gazeux de N2 et H2 dans un réacteur plasma pour la gravure, puis effectuer un nettoyage humide afin de retirer les résidus de résine. Ce nettoyage peut être effectué à l'aide d'une solution SC1.

La figure 3c illustre également au moins une étape d'épitaxie réalisée à partir de la couche semi conductrice 103 située sous les premiers empilements 200a et 200b. Par exemple, au cours de cette étape d'épitaxie, on fait croître successivement :
- de part et d'autre de l'empilement 200a et à partir de la couche 103 faite de silicium : des zones de silicium-germanium 601a puis des zones de silicium 602a.
- de part et d'autre de l'empilement 200b et à partir de la couche 103 faite de silicium-germanium: des zones de silicium-germanium 601b puis des zones de silicium 602b.

Dans le cas où les premiers empilements 200a, 200b sont de type P, les matériaux que l'on fait croître par épitaxie sont par exemple dopés au bore.

Ces zones formées par épitaxie sont destinées à former des sources et drain 600a, 600b pour les empilements 200a et 200b. Ces zones sont en partie au contact des flancs 210a, 210b formés par les espaceurs 206a, 206b des empilements 200a, 200b.

Les portions de matériaux conducteurs situés sous les deuxièmes empilements 300a, 300b ne font pas l'objet d'une croissance par épitaxie puisque ces portions sont protégées par la couche de protection 400 qui n'a pas été gravée à l'étape précédente.

La figure 3d correspond à l'étape 402 de la figure 4 et illustre une étape de dépôt de la couche 700 à base de nitrure de silicium. Ce dépôt est conforme. Ainsi, la couche 700 recouvre chacun des empilements 200a, 200b, 300a, 300b ainsi que leurs éventuelles sources et drains 600a, 600b. Cette couche 700 est par exemple déposée par un procédé de type PEALD (dépôt par couche atomique assisté par plasma). Selon un mode de réalisation non limitatif, cette couche 700 est déposée à une température supérieure ou égale à 550°C.

La figure 3e illustre l'étape de modification anisotrope de la couche 700 et correspond à l'étape 403 de la figure 4. La modification est effectuée par implantation 1000 d'ions hydrogène selon une direction principale z parallèle au plan principal xy dans lequel s'étend le substrat 100.

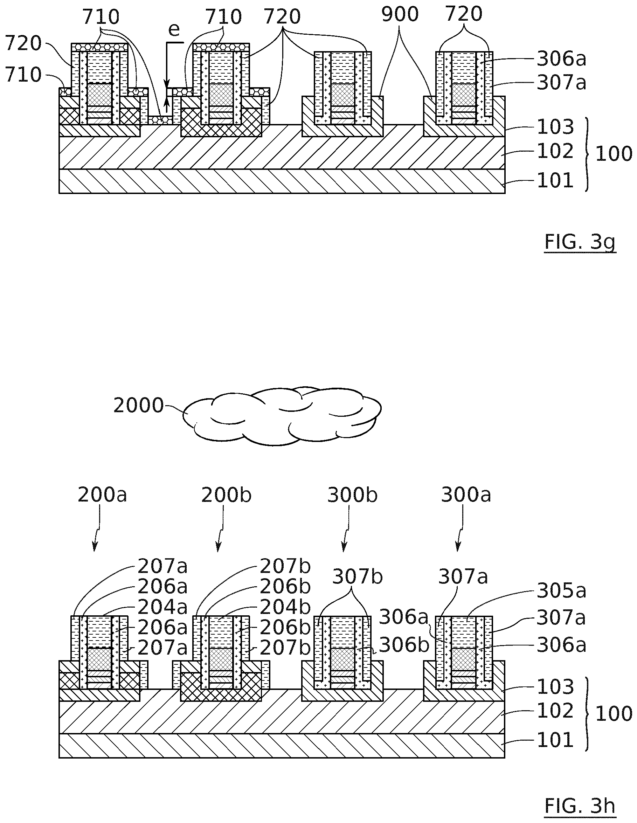

La profondeur d'implantation correspond à la référence e2 illustrée en figure 3g. Ainsi la direction de l'implantation est parallèle aux flancs des motifs si ces derniers sont perpendiculaire audit plan xy. Des exemples d'implantation et d'équipements pour réaliser cette implantation 1000, notamment par plasma, ont été décrits précédemment.

Les paramètres d'implantation, en particulier l'énergie communiquée aux ions, la durée et la dose d'implantation sont prévus de sorte que :
- les zones modifiées 710 de la couche 700 soient situées sur le sommet des motifs et entre les motifs 200a, 200b, 300a, 300b. Dans ces zones, de préférence toute l'épaisseur de la couche 700 est modifiée. Dans ces zones modifiées 710, le matériau de la couche 700 est donc enrichi en ions hydrogène.
- il subsiste des zones non modifiées 720 sur les flancs des motifs 200a, 200b, 300a, 300b. Dans l'exemple illustré, les flancs des motifs sont formés par la couche de protection 400. De préférence, toute l'épaisseur de la couche 700 est exempte d'implantation. Selon un mode de réalisation alternatif, une portion seulement de l'épaisseur de la couche 700 est implantée.

La figure 3f illustre une étape suivante au cours de laquelle on forme une couche de masquage 800 pour recouvrir entièrement les premiers empilements 200a, 200b de grille, c'est-à-dire dans ce cas les empilements destinés à former des transistors de type P. Les empilements 300a, 300b destinés à former des transistors de type N ne sont pas recouverts par la couche de masquage 800. Selon un mode de réalisation alternatif, les empilements 300a, 300b destinés à former des transistors de type N sont masqués lors de cette étape et les empilements 200a, 200b destinés à former des transistors de type P ne sont pas recouverts.

Cette couche de masquage 800 est typiquement une couche de résine, déposée pleine plaque, puis ouverte au niveau des premiers empilements 200a, 200b par l'une des techniques conventionnelles de lithographie.

Le dépôt de cette couche de masquage correspond à l'étape 404 de la figure 4.

L'étape suivante, également illustrée en figure 3f, vise à conserver la couche 700 à base de nitrure de silicium et la couche de protection 400 sur les flancs des deuxièmes empilements 300a, 300b et à retirer ces couches 700, 400 en dehors des flancs des deuxièmes empilements 300a, 300b. Au niveau des flancs des deuxièmes empilements 300a, 300b la couche 700 forme ainsi des espaceurs 307a, 307b qui se superposent aux espaceurs 306a, 306b formés par la couche de protection 400.

De préférence pour effectuer ces gravures anisotropes des couches 700 et 400, on effectue une gravure plasma bien connue de l'homme du métier. On pourra par exemple utiliser une chimie fluorocarbonée.

Il s'agit donc d'une gravure anisotrope des portions modifiées 710 par rapport aux portions non modifiées 720 de la couche 700 à base de nitrure de silicium.

De préférence, la gravure anisotrope retire toute l'épaisseur des couches 700 et 400 sur le sommet des empilements 300a, 300b. Sur le flanc des motifs 300a, 300b, la couche de protection 400 reste protégée par les espaceurs 307a et 307b.

De préférence, la gravure anisotrope ne retire pas ou ne retire qu'une portion de l'épaisseur de la couche 700 sur le flanc des motifs 300a, 300b.

Sur le flanc des motifs 300a, 300b, la couche de protection 400 reste protégée par les espaceurs 307a et 307b.

Par ailleurs lors de la gravure de la couche 700 à base de nitrure de silicium et de la couche de protection 400, les premiers empilements 200a, 200b, c'est-à-dire les zones de type P, demeurent protégés par la couche de masquage 800.

Selon ce mode de réalisation privilégié, une seule étape de gravure permet de retirer la couche 700 et la couche 400 en dehors des flancs des deuxièmes motifs 300a, 300b, ce qui permet d'augmenter les cadences de production. Selon un mode de réalisation alternatif, on utilise deux gravures différentes pour graver la couche 700 puis la couche 400.

Cette étape de gravure sélective correspond à l'étape 405 de la figure 4.

Comme illustré en figure 3g, la couche de masquage 800 est ensuite retirée. Lorsque cette couche de masquage 800 est une résine photosensible, on pourra utiliser les techniques mentionnées ci-dessus pour retirer la couche de masquage 500 illustrée en figure 3c. Cette figure 3g correspond à l'étape 406 de la figure 4.

La figure 3g illustre également au moins une étape d'épitaxie réalisée à partir de la couche semi conductrice 103 située sous les deuxièmes empilements 300a et 300b. Par exemple, au cours de cette étape d'épitaxie, on fait croître successivement de part et d'autre des empilements 300a, 300b et à partir de la couche 103 faite de silicium : des zones de silicium.

Dans cet exemple où les premiers empilements 200a, 200b sont de type P, l'épitaxie est effectuée de manière à ce que le silicium épitaxié soit dopé au phosphore.

Ces zones formées par épitaxie sont destinées à former des sources et drain 900 pour les empilements 300a et 300b. Ces zones sont en partie au contact des flancs formés par les espaceurs 307a, 307b des empilements 300a, 300b.

L'étape suivante, illustrée en figure 3h, vise à retirer les zones modifiées 710 de la couche à base de nitrure de silicium tout en conservant les zones non modifiées 720 sur les flancs des premiers motifs 200a, 200b et des deuxièmes motifs 300a, 300b. Les zones non modifiées 720 sur les flancs des premiers motifs 200a, 200b forment ainsi des espaces traditionnels 207a, 207b.

Avec les procédés conventionnels, cette étape serait particulièrement délicate puisqu'il faudrait graver la couche à base de nitrure de silicium en limitant la consommation de la couche semi-conductrice 103, des sources et drain 900 et de la couche isolante 102 lors de cette gravure.

Dans le cadre de l'invention, le retrait de la couche à base de nitrure de silicium 700 en dehors des flancs des premiers motifs 200a, 200b est effectuée par une gravure plasma 2000 utilisant une chimie comprenant au moins :
∘ un composé pris parmi les fluorocarbures (CₓF_{z}) ou les hydrofluorocarbures (CₓH_{y}F_{z}), et
∘ au moins un composé pris parmi Si_{w}Cl(2_{w}+2) et Si_{w}F(2_{w}+2), avec de préférence w = 1 ou w = 2. et au moins un composé pris parmi l'oxygène et l'azote.

Comme indiqué ci-dessus, cette gravure permet de retirer rapidement les zones modifiées 710 à base de nitrure de silicium avec une très forte sélectivité vis-à-vis de la couche semi conductrice 103 faite par exemple de silicium et de la couche isolante 102 faite par exemple d'oxyde de silicium. Par conséquent ces deux dernières couches 102, 103 ne sont pas altérées et les performances du transistor sont améliorées.

Par ailleurs, cette gravure permet de retirer les zones modifiées 710 avec une très forte sélectivité vis-à-vis des zones non modifiées 720. L'invention permet ainsi un contrôle dimensionnel amélioré.

L'épaisseur gravée est illustrée par la référence e en figure 3g. Ainsi toute les zones modifiées 710 situées sur le sommet des premiers motifs 200a, 200b sont retirées. En revanche il n'y a pas de consommation des espaceurs 307a, 307b et éventuellement des espaceurs 306a, 306b puisque la gravure est sélective des zones implantées par rapport aux zones non implantées.

Cette étape de gravure sélective correspond à l'étape 407 illustrée en figure 4. Lors de cette étape de retrait, la chimie de la gravure plasma 2000 comprend également de l'oxygène ou de l'azote. De préférence, on injecte du O2 ou un gaz comprenant du N2 dans le réacteur plasma. Cela permet de limiter la polymérisation.

Par exemple, on injectera du O2 avec le ratio R suivant :
R= A / {B + C) < 0.23 et de préférence A / {B + C) ≤ 0.2, avec
A= débit de O2, de N2 ou de O2+N2.
B= débit de l'au moins un composé pris parmi les composés fluorocarbonés (CₓF_{z}) ou les composés hydrofluorocarbonés (CₓH_{y}F_{z}),
C= débit de l'au moins un composé pris parmi le Si_{w}F(2_{w}+2).

De préférence, 0.1 ≤ R
Selon un mode de réalisation, 0.1 ≤ R ≤ 0.23
Si la concentration d'oxygène est trop faible la gravure peut s'arrêter par formation d'un polymère fluorocarboné. À l'inverse, si la concentration d'oxygène est trop élevée la gravure va également s'arrêter cette fois ci due à une oxydation du matériau.

De même, on aura 0.2 ≤R' = A / { B + C') ≤ 2 et de préférence 0.5≤R' = A / { B + C') ≤ 1.5. Selon un mode de réalisation 0.75 ≤R' = A / { B + C') ≤ 1.25, et avantageusement 0.9 ≤R' = A/{B + C') ≤ 1.1, avec:
A= débit de O2 ou de N2 ou de O2+N2.
B= débit de l'au moins un composé pris parmi les composés fluorocarbonés (CₓF_{z}) ou les composés hydrofluorocarbonés (CₓH_{y}F_{z}),
C'= débit de l'au moins un composé pris parmi le Si_{w}Cl(2_{w}+2) et de préférence = SiCl4.

Dans le cas de la chimie SiCl4 un ratio R'=débit O2 / (SiCL4+FC)= 1 est particulièrement performant.

### Exemples particuliers et non limitatifs de la présente invention

Des exemples détaillés de réalisation vont maintenant être décrits. Les valeurs numériques indiquées ci-dessous s'appliquent possiblement à tous les modes de réalisation couverts par les revendications et en particulier à tous les modes de réalisation décrits en référence aux figures. Les valeurs numériques indiquées ci-dessous ne sont donc pas limitatives.

Des exemples de densité de plasma et d'énergies qui peuvent être communiquées aux espèces implantées sont résumés dans le tableau suivant:

**Tableau 1 :**

| | Type de plasma | | |
|---|---|---|---|
| | CCP | ICP | Immersion |
| Densité (atomes/cm³) : | 10⁹ - 10¹⁰ | 10¹⁰ - 10¹² | = ou > à 10¹³ |
| Énergie des ions (eV) | 10-1000 et de préférence 200-500 | 1-1000 et de préférence 15-1000 | jusqu'à 25×10³ |
| Pression (10⁻³ Torr) | 10-1000 | 1-10 | |

### 1. Modification de la couche à base de nitrure 700

Afin de modifier une couche à base de nitrure 700 on peut par exemple appliquer les paramètres suivants en particulier pour un plasma de type ICP. Ces paramètres donnent des résultats particulièrement intéressants pour une couche à base de nitrure 700 d'épaisseur comprise entre 5 et 20 nm et typiquement de 10 nm, cette couche 700 ayant été formée par dépôt conforme de type PEALD (dépôt par couche atomique assisté par plasma) à une température supérieure à 500°C.

**Tableau 2 :**

| | |
|---|---|
| Épaisseur modifiée : | de 1 nm à quelques dizaines de nm. Typiquement de 1 à 20 nm |
| Chimie : | Gaz à base d'Hydrogène, typiquement (H2) 10 à 500sccm |
| Puissance de la source : | 0-2000 Watts |
| Puissance de la polarisation (bias) : | 20 V à 500 V |
| Pression : | 5 à 100 milli Torr |
| Température : | 10°C à 100°C |
| Temps: | de quelques secondes à quelques centaines de secondes |

La puissance de la polarisation et la puissance de la source peuvent être pulsées ou continues.

Les fenêtres des tableaux ci-dessus sont larges et dépendent des applications spécifiques du procédé de l'invention et notamment de l'épaisseur que l'on souhaite modifier dans la couche 700 à base de nitrure de silicium.

Par exemple, pour modifier une couche de nitrure de silicium 700 sur une profondeur de 15 nm dans un équipement de gravure de type ICP on pourra appliquer les paramètres suivants :

**Tableau 3 :**

| | |
|---|---|
| Épaisseur modifiée : | 15 nm |
| Chimie : | H2 à 50 sccm |
| Puissance de la source : | 200 Watts |
| Puissance de la polarisation (bias) : | 350 V |
| Pression : | 10 milli Torr |
| Température : | 10°C à 100°C |
| Temps : | 60 secondes |

### 2. Retrait de l'au moins une zone modifiée

Afin de graver les zones modifiées 710 sélectivement aux zones non modifiées 720 de la couche à base de nitrure 700 on peut par exemple appliquer les paramètres suivants en particulier pour un plasma de type ICP.

**Tableau 4 :**

| | |
|---|---|
| Épaisseur modifiée : | de 1 nm à quelques dizaines de nm. Typiquement de 1 à 20 nm |
| Chimie : | Gaz fluorocarboné : CxHyFz (10sccm à 500sccm) dilué dans dans l'O2 (10sccm à 1000sccm) et Gaz 2 SiCl4 ou SiF4 (5 à 15sccm) |
| Puissance de la source : | 100-1000 Watts |
| Puissance de la polarisation (bias) : | 50 V à 500 V |
| Pression : | 10 à 80 milli Torr |
| Température : | 10°C à 100°C |
| Temps: | de quelques secondes à quelques centaines de secondes |

La puissance de la polarisation et la puissance de la source peuvent être continues ou puisées.

Dans ce dernier cas on peut prévoir une fréquence comprise entre 200Hz et 5Khz avec un duty cycle (temps d'activation du plasma par rapport à la période) compris entre 20% à 100%.

Les fenêtres des tableaux ci-dessus sont larges et dépendent des applications spécifiques du procédé de l'invention et notamment de l'épaisseur que l'on souhaite graver dans la couche 700 à base de nitrure de silicium.

Par exemple, pour graver une couche de nitrure de silicium 700 qui aura été au préalable modifiée selon les paramètres du tableau 3 ci-dessus, on pourra appliquer les paramètres du tableau 4 pendant une durée de 30 secondes avec une chimie FC+SiCl4. On obtiendra alors une consommation moyenne de SiN de 6,7 nm.

L'invention n'est pas limitée aux seuls modes et exemples de réalisation décrits ci-dessus, mais s'étend à tous les modes de réalisation entrant dans la portée des revendications.

## Revendications

1. Procédé de gravure d'une couche (700) à base de nitrure de silicium comprenant les étapes successives suivantes:
- modification de la couche (700) à base de nitrure de silicium (SiN) de manière à former au moins une zone modifiée (710), la modification comprenant au moins une implantation (1000) d'ions à base d'hydrogène (H) et/ou d'hélium (He) dans la couche (700) à base de SiN;
- retrait de l'au moins une zone modifiée (710) ;
**caractérisé en ce que** le retrait de l'au moins une zone modifiée (710) comprend au moins une étape de gravure par plasma de l'au moins une zone modifiée (710) utilisant une chimie comprenant au moins:
∘ au moins un composé pris parmi les composés fluorocarbonés (CₓF_{z}) ou les composés hydrofluorocarbonés (CₓH_{y}F_{z}), et
∘ au moins un composé pris parmi le Si_{w}Cl(2_{w}+2) et le Si_{w}F(2_{w}+2)
∘ au moins un composé pris parmi l'oxygène ou l'azote.

2. Procédé selon la revendication précédente, dans lequel la couche (700) à base de SiN est formée à une température supérieure ou égale à 500°C et de préférence supérieure ou égale à 550°C.

3. Procédé selon l'une quelconque des revendications précédentes dans lequel la couche (700) à base de SiN surmonte, de préférence en étant au contact de, une couche faite d'un matériau pris parmi:
- un matériau semi-conducteur, de préférence pris parmi le silicium (Si), le germanium (Ge) et alliage de silicium et de germanium (SiGe),
- un oxyde de silicium (SiOx).

4. Procédé selon l'une quelconque des revendications précédentes, dans lequel la couche (700) à base de SiN est faite d'un matériau comprenant ou constitué de l'un des matériaux suivants: le SiN, le SiCN, le SiCBN.

5. Procédé selon l'une quelconque des revendications précédentes, dans lequel l'implantation (1000) est réalisée de manière anisotrope, selon au moins une direction principale (z) d'implantation sensiblement perpendiculaire au plan (xy) dans lequel s'étend la couche (700) à base de SiN ou un substrat (100) sur lequel est disposé la couche (700) à base de SiN.

6. Procédé selon l'une quelconque des revendications précédentes, dans lequel l'implantation (1000) dans la couche (700) à base de SiN (910) est effectuée à travers un masque, comportant de préférence au moins un motif de résine (500, 800).

7. Procédé selon l'une quelconque des revendications précédentes, dans lequel la couche (700) à base de SiN recouvre au moins un motif (200, 200a, 200b, 300a, 300b) présentant des flancs (210, 210a, 210b, 310a, 310b) et l'implantation (1000) desdits ions est réalisée de manière anisotrope selon une direction principale (z) d'implantation parallèle auxdits flancs (210, 210a, 210b, 310a, 310b).

8. Procédé selon la revendication précédente, dans lequel la modification de la couche (700) à base de SiN est effectuée de manière à ce que le retrait de ladite au moins une zone modifiée (710) retire toute la couche (700) à base de SiN en dehors des flancs de l'au moins un motif (200, 200a, 200b, 300a, 300b) et laisse en place au moins une partie de la couche (700) à base de SiN recouvrant les flancs de l'au moins un motif (200, 200a, 200b, 300a, 300b).

9. Procédé selon l'une quelconque des deux revendications précédentes, dans lequel l'au moins un motif (200, 200a, 200b, 300a, 300b) forme ou comprend un empilement de grille d'un transistor situé au-dessus d'une couche (103) en un matériau semi-conducteur et dans lequel l'étape de modification est effectuée de manière à implanter les ions sur toute l'épaisseur de la couche (700) à base de SiN en dehors des flancs de l'empilement de la grille et dans lequel les étapes d'implantation (1000) et de retrait de ladite au moins une zone modifiée (710) sont effectuées de manière à graver ladite au moins une zone modifiée (710) sélectivement au matériau semi-conducteur à des zones non modifiées (720) de la couche (700) à base de SiN.

10. Procédé selon la revendication précédente, dans lequel les étapes d'implantation (1000) et de retrait de ladite au moins une zone modifiée (710) sont effectuées de manière à conserver sur les flancs de l'au moins un motif (200, 200a, 200b, 300a, 300b) des zones non modifiées (720) formant des espaceurs (207a, 207b, 307a, 307b) de grille.

11. Procédé selon l'une quelconque des revendications 1 à 9, dans lequel,
∘ avant les étapes de modification (403) de la couche (700) à base de SiN et de retrait (407) de l'au moins une zone modifiée (710), on effectue l'étape suivante :
- une étape (401) de fourniture d'un substrat (100) surmonté d'au moins un premier motif (200a, 200b) de grille et d'au moins un deuxième motif (300a, 300b) de grille, la couche (700) à base de SiN recouvrant les premier (200a, 200b) et deuxième (300a, 300b) motifs de grille, lesdits motifs (200a, 200b, 300a, 300b) présentant des flancs ;
∘ l'implantation (1000) desdits ions est réalisée de manière à former des zones modifiées (710) de la couche (700) à base de SiN en dehors des flancs et à conserver une portion au moins de l'épaisseur de la couche (700) à base de SiN sur lesdits flancs, lesdites portions définissant des zones non modifiées (720),
∘ après l'étape de modification (403) de la couche (700) à base de SiN et avant l'étape de retrait (407) de l'au moins une zone modifiée (710), on effectue les étapes suivantes :
- masquage (404) du premier motif (200a, 200b) de grille par une couche de masquage (800) ;
- retrait (405) des zones modifiées (710) de la couche (700) à base de SiN située sur le deuxième motif (300a, 300b) de grille sélectivement aux zones non modifiées (720) situées sur le deuxième motif (300a, 300b) de grille ;
- retrait (406) de la couche de masquage (800) de manière à mettre à nu la couche (700) à base de SiN située sur le premier motif (200a, 200b) de grille.

12. Procédé selon la revendication précédente dans lequel le premier motif (200a, 200b) de grille est un premier empilement de grille d'un transistor d'un type N ou P et dans lequel le deuxième motif (300a, 300b) de grille est un deuxième empilement de grille d'un transistor d'un type différent du type du premier empilement de grille.

13. Procédé selon la revendication précédente dans lequel le substrat (100) est surmonté d'une pluralité de premiers motifs (200a, 200b) de grille et d'une pluralité de deuxièmes motifs (300a, 300b) de grille, l'une parmi la pluralité de premiers motifs (200a, 200b) de grille et la pluralité de deuxièmes motifs (300a, 300b) de grille comprend au moins un premier type d'empilement (200a, 300a) de grille et un deuxième type d'empilement (200b, 300b) de grille chacun des premier et deuxième types d'empilements de grille comprenant au moins une couche isolante (201a, 201b, 301a, 301b), typiquement un oxyde de grille et dans lequel l'épaisseur de la couche isolante (201a, 201b) du premier type d'empilement (200a, 300a) de grille diffère de l'épaisseur de la couche isolante (301a, 301b) du deuxième type d'empilement (200b, 300b) de grille.

14. Procédé selon la revendication 12 dans lequel le premier motif de grille (200a, 200b) est un motif sacrificiel, dans lequel le deuxième motif (300a, 300b) est un motif sacrificiel, le procédé comprenant, après ladite étape de retrait des zones modifiées (710) de la couche de nitrure (700), une étape de remplacement des premier (200a, 200b) et deuxième motifs (300a, 300b) sacrificiels par des motifs formant respectivement un premier empilement de grille et un deuxième empilement de grille.

## Patentansprüche

1. Verfahren zum Ätzen einer Schicht (700) auf der Basis von Siliciumnitrid, umfassend die folgenden aufeinanderfolgenden Schritte:
- Modifizieren der Schicht (700) auf der Basis von Siliciumnitrid (SiN), um mindestens eine modifizierte Zone (710) zu bilden, wobei das Modifizieren mindestens ein Implantieren (1000) von Ionen auf der Basis von Wasserstoff (H) und/oder Helium (He) in die Schicht (700) auf der Basis von SiN umfasst;
- Abziehen der mindestens einen modifizierten Zone (710);
**dadurch gekennzeichnet, dass** das Abziehen der mindestens einen modifizierten Zone (710) mindestens einen Schritt eines Plasmaätzens der mindestens einen modifizierten Zone (710) unter Verwendung einer Chemie, umfassend mindestens:
∘ mindestens eine Verbindung, die aus Fluorkohlenstoffverbindungen (CₓF_{z}) oder Fluorkohlenwasserstoffverbindungen (CₓH_{y}F_{z}) ausgewählt ist, und
∘ mindestens eine Verbindung, die aus Si_{w}Cl(2_{w}+2) und Si_{w}F(2_{w}+2) ausgewählt ist,
∘ mindestens eine Verbindung, die aus Sauerstoff oder Stickstoff ausgewählt ist.

2. Verfahren nach dem vorhergehenden Anspruch, wobei die Schicht (700) auf der Basis von SiN bei einer Temperatur größer als oder gleich 500°C und vorzugsweise größer als oder gleich 550°C gebildet wird.

3. Verfahren nach einem der vorhergehenden Ansprüche, wobei die Schicht (700) auf der Basis von SiN auf einer Schicht aufliegt, vorzugsweise mit einer Schicht in Kontakt steht, die aus einem Material hergestellt ist, das ausgewählt ist aus:
- einem Halbleitermaterial, das vorzugsweise aus Silicium (Si), Germanium (Ge) und einer Silicium-Germanium-Legierung (SiGe) ausgewählt ist,
- einem Siliciumoxid (SiOx).

4. Verfahren nach einem der vorhergehenden Ansprüche, wobei die Schicht (700) auf der Basis von SiN aus einem Material hergestellt ist, das eines der folgenden Materialien umfasst oder aus einem der folgenden Materialien besteht: SiN, SiCN, SiCBN.

5. Verfahren nach einem der vorhergehenden Ansprüche, wobei das Implantieren (1000) anisotrop gemäß mindestens einer Hauptimplantationsrichtung (z), die im Wesentlichen senkrecht zu der Ebene (xy) ist, in der sich die Schicht (700) auf der Basis von SiN oder ein Substrat (100), auf dem die Schicht (700) auf der Basis von SiN angeordnet ist, erstreckt, durchgeführt wird.

6. Verfahren nach einem der vorhergehenden Ansprüche, wobei das Implantieren (1000) in die Schicht (700) auf der Basis von SiN (910) durch eine Maske ausgeführt wird, die vorzugsweise mindestens eine Harzstruktur (500, 800) umfasst.

7. Verfahren nach einem der vorhergehenden Ansprüche, wobei die Schicht (700) auf der Basis von SiN mindestens eine Struktur (200, 200a, 200b, 300a, 300b) abdeckt, das Seiten (210, 210a, 210b, 310a, 310b) aufweist, und das Implantieren (1000) der Ionen anisotrop gemäß einer Hauptimplantationsrichtung (z), die zu den Seiten (210, 210a, 210b, 310a, 310b) parallel ist, durchgeführt wird.

8. Verfahren nach dem vorhergehenden Anspruch, wobei das Modifizieren der Schicht (700) auf der Basis von SiN ausgeführt wird, so dass das Abziehen der mindestens modifizierten Zone (710) die gesamte Schicht (700) auf der Basis von SiN außerhalb der Seiten der mindestens einen Struktur (200, 200a, 200b, 300a, 300b) entfernt und mindestens einen Teil der Schicht (700) auf der Basis von SiN, der die Seiten der mindestens einen Struktur (200, 200a, 200b, 300a, 300b) abdeckt, zurücklässt.

9. Verfahren nach einem von zwei vorhergehenden Ansprüchen, wobei die mindestens eine Struktur (200, 200a, 200b, 300a, 300b) einen Gate-Stapel eines Transistors, der sich über einer Schicht (103) aus einem Halbleitermaterial befindet, bildet oder diesen umfasst und wobei der Schritt des Modifizierens ausgeführt wird, so dass die Ionen über die gesamte Dicke der Schicht (700) auf der Basis von SiN außerhalb von Seiten des Gate-Stapels implantiert werden, und wobei die Schritte des Implantierens (1000) und des Abziehens der mindestens einen modifizierten Zone (710) ausgeführt werden, so dass die mindestens eine modifizierte Zone (710) selektiv in Bezug auf das Halbleitermaterial an nicht modifizierten Zonen (720) der Schicht (700) auf der Basis von SiN geätzt wird.

10. Verfahren nach dem vorhergehenden Anspruch, wobei die Schritte des Implantierens (1000) und des Abziehens der mindestens einen modifizierten Zone (710) ausgeführt werden, so dass nicht modifizierte Zonen (720), die Gate-Abstandshalter (207a, 207b, 307a, 307b) bilden, auf den Seiten der mindestens einen Struktur (200, 200a, 200b, 300a, 300b) zu bewahren.

11. Verfahren nach einem der Ansprüche 1 bis 9, wobei
∘ vor den Schritten des Modifizierens (403) der Schicht (700) auf der Basis von SiN und des Abziehens (407) der mindestens einen modifizierten Zone (710) der folgende Schritt ausgeführt wird:
- ein Schritt (401) eines Bereitstellens eines Substrats (100), auf dem mindestens eine erste Gate-Struktur (200a, 200b) und mindestens eine zweite Gate-Struktur (300a, 300b) aufliegen, wobei die Schicht (700) auf der Basis von SiN die erste (200a, 200b) und die zweite (300a, 300b) Gate-Struktur abdecken, wobei die Strukturen (200a, 200b, 300a, 300b) Seiten aufweisen;
∘ das Implantieren (1000) von Ionen durchgeführt wird, so dass modifizierte Zonen (710) der Schicht (700) auf der Basis von SiN außerhalb von Seiten gebildet werden und ein Abschnitt von mindestens der Dicke der Schicht (700) auf der Basis von SiN auf den Seiten bewahrt wird, wobei die Abschnitte nicht modifizierte Zonen (720) definieren,
∘ nach dem Schritt des Modifizierens (403) der Schicht (700) auf der Basis von SiN und vor dem Schritt des Abziehens (407) der mindestens einen modifizierten Zone (710) die folgenden Schritte ausgeführt werden:
- Maskieren (404) der ersten Gate-Struktur (200a, 200b) durch eine Maskenschicht (800);
- Abziehen (405) von modifizierten Zonen (710) der Schicht (700) auf der Basis von SiN, die sich auf der zweiten Gate-Struktur (300a, 300b) befinden, selektiv in Bezug auf nicht modifizierte Zonen (720), die sich auf der zweiten Gate-Struktur (300a, 300b) befinden;
- Abziehen (406) der Maskenschicht (800), so dass die Schicht (700) auf der Basis von SiN, die sich auf der ersten Gate-Struktur (200a, 200b) befindet, freigelegt wird.

12. Verfahren nach dem vorhergehenden Anspruch, wobei die erste Gate-Struktur (200a, 200b) ein erster Gate-Stapel eines Transistors eines n- oder p-Typs ist und wobei die zweite Gate-Struktur (300a, 300b) ein zweiter Gate-Stapel eines Transistors eines von dem ersten Gate-Stapel unterschiedlichen Typs ist.

13. Verfahren nach dem vorhergehenden Anspruch, wobei auf dem Substrat (100) mehrere erste Gate-Strukturen (200a, 200b) und mehrere zweite Gate-Strukturen (300a, 300b) aufliegen, wobei eine von den mehreren ersten Gate-Strukturen (200a, 200b) und von den mehreren zweiten Gate-Strukturen (300a, 300b) mindestens einen ersten Gate-Stapeltyp (200a, 300a) und einen zweiten Gate-Stapeltyp (200b, 300b) umfasst, wobei jeder von dem ersten und dem zweiten Gate-Stapeltyp mindestens eine Isolierschicht (201a, 201b, 301a, 301b), in der Regel ein Gate-Oxid umfasst und wobei die Dicke der Isolierschicht (201a, 201b) des ersten Gate-Stapeltyps (200a, 300a) sich von der Dicke der Isolierschicht (301a, 301b) des zweiten Gate-Stapeltyps (200b, 300b) unterscheidet.

14. Verfahren nach Anspruch 12, wobei die erste Gate-Struktur (200a, 200b) eine Opferstruktur ist, wobei die zweite Struktur (300a, 300b) eine Opferstruktur ist, wobei das Verfahren nach dem Schritt des Abziehens von modifizierten Zonen (710) der Nitridschicht (700) einen Schritt eines Ersetzens der ersten (200a, 200b) und der zweiten Opferstruktur (300a, 300b) durch Strukturen umfasst, die einen ersten Gate-Stapel bzw. einen zweiten Gate-Stapel bilden.

## Claims

1. Method for etching a silicon nitride-based layer (700) comprising the following successive steps of:
- modifying the silicon nitride (SiN)-based layer (700) so as to form at least one modified region (710), the modification comprising at least one implantation (1000) of hydrogen (H)-based and/or helium (He)-based ions in the SiN-based layer (700);
- removing the at least one modified region (710);
**characterised in that** the removal of the at least one modified region (710) comprises at least one step of plasma etching the at least one modified region (710) using a chemistry comprising at least:
∘ at least one compound selected from fluorocarbon compounds (CₓF_{z}) or hydrofluorocarbon compounds (CₓH_{y}F_{z}), and
∘ at least one compound selected from Si_{w}Cl(2_{w}+2) and Si_{w}F(2_{w}+2)
∘ at least one compound selected from oxygen or nitrogen.

2. Method according to the preceding claim, wherein the SiN-based layer (700) is formed at a temperature greater than or equal to 500°C and preferably greater than or equal to 550°C.

3. Method according to any one of the preceding claims, wherein the SiN-based layer (700) overlies, preferably while being in contact therewith, a layer made of a material selected from:
- a semiconductor material, preferably selected from silicon (Si), germanium (Ge) and a silicon and germanium (SiGe) alloy,
- a silicon oxide (SiOx).

4. Method according to any one of the preceding claims, wherein the SiN-based layer (700) is made of a material comprising or consisting of one of the following materials: SiN, SiCN, SiCBN.

5. Method according to any one of the preceding claims, wherein the implantation (1000) is carried out anisotropically, in at least one main direction (z) of implantation substantially perpendicular to the plane (xy) in which extends the SiN-based layer (700) or a substrate (100) on which the SiN-based layer (700) is disposed.

6. Method according to any one of the preceding claims, wherein the implantation (1000) in the SiN (910)-based layer (700) is carried out through a mask, preferably including at least one resist pattern (500, 800).

7. Method according to any one of the preceding claims, wherein the SiN-based layer (700) covers at least one pattern (200, 200a, 200b, 300a, 300b) having sidewalls (210, 210a, 210b, 310a, 310b) and the implantation (1000) of said ions is carried out anisotropically in a main direction (z) of implantation parallel to said sidewalls (210, 210a, 210b, 310a, 310b).

8. Method according to the preceding claim, wherein the modification of the SiN-based layer (700) is carried out such that the removal of said at least one modified region (710) removes all of the SiN-based layer (700) outside of the sidewalls of the at least one pattern (200, 200a, 200b, 300a, 300b) and leaves in place at least a part of the SiN-based layer (700) covering the sidewalls of the at least one pattern (200, 200a, 200b, 300a, 300b).

9. Method according to any one of the preceding two claims, wherein the at least one pattern (200, 200a, 200b, 300a, 300b) forms or comprises a gate stack of a transistor located above a layer (103) made of a semiconductor material, and wherein the modification step is carried out so as to implant the ions throughout the entire thickness of the SiN-based layer (700) outside of the sidewalls of the stack of the gate, and wherein the steps of implanting (1000) and of removing said at least one modified region (710) are carried out so as to etch said at least one modified region (710) selectively to the semiconductor material at unmodified regions (720) of the SiN-based layer (700).

10. Method according to the preceding claim, wherein the steps of implanting (1000) and of removing said at least one modified region (710) are carried out in such a way as to retain on the sidewalls of the at least one pattern (200, 200a, 200b, 300a, 300b) unmodified regions (720) forming gate spacers (207a, 207b, 307a, 307b).

11. Method according to any one of claims 1 to 9, wherein
∘ before the steps of modifying (403) the SiN-based layer (700) and of removing (407) the at least one modified region (710), the following step is carried out:
- a step (401) of providing a substrate (100) overlaid by at least one first gate pattern (200a, 200b) and at least one second gate pattern (300a, 300b), the SiN-based layer (700) covering the first (200a, 200b) and second (300a, 300b) gate patterns, said patterns (200a, 200b, 300a, 300b) having sidewalls;
∘ the implantation (1000) of said ions is carried out so as to form modified regions (710) of the SiN-based layer (700) outside of the sidewalls and to retain at least a portion of the thickness of the SiN-based layer (700) on said sidewalls, said portions defining unmodified regions (720),
∘ after the step of modifying (403) the SiN-based layer (700) and before the step of removing (407) the at least one modified region (710), the following steps are carried out:
- masking (404) the first gate pattern (200a, 200b) with a masking layer (800);
- removing (405) the modified regions (710) of the SiN-based layer (700) located on the second gate pattern (300a, 300b) selectively to the unmodified regions (720) located on the second gate pattern (300a, 300b);
- removing (406) the masking layer (800) so as to expose the SiN-based layer (700) located on the first gate pattern (200a, 200b).

12. Method according to the preceding claim, wherein the first gate pattern (200a, 200b) is a first gate stack of an n-type or p-type transistor and wherein the second gate pattern (300a, 300b) is a second gate stack of a transistor of a type that is different from the type of the first gate stack.

13. Method according to the preceding claim, wherein the substrate (100) is overlaid by a plurality of first gate patterns (200a, 200b) and a plurality of second gate patterns (300a, 300b), one of the plurality of first gate patterns (200a, 200b) and the plurality of second gate patterns (300a, 300b) comprises at least a first type of gate stack (200a, 300a) and a second type of gate stack (200b, 300b), each of the first and second types of gate stacks comprising at least one insulating layer (201a, 201b, 301a, 301b), typically a gate oxide, and wherein the thickness of the insulating layer (201a, 201b) of the first type of gate stack (200a, 300a) differs from the thickness of the insulating layer (301a, 301b) of the second type of gate stack (200b, 300b).

14. Method according to claim 12, wherein the first gate pattern (200a, 200b) is a sacrificial pattern, wherein the second pattern (300a, 300b) is a sacrificial pattern, the method comprising, after said step of removing the modified regions (710) of the nitride layer (700), a step of replacing the first (200a, 200b) and second (300a, 300b) sacrificial patterns with patterns forming a first gate stack and a second gate stack respectively.
